# EUROPEAN PATENT APPLICATION

(11) **EP 4 790 441 A1**
(43) Date of publication of application: **12.08.2026**
(21) Application number: 26152769.1
(22) Date of filing: 19.01.2026
(51) Int. Cl.: G01R 33/00, G01R 33/09

(54) **XMR SENSOR WITH CONTINUOUS-TIME COIL COMPENSATION LOOP**

(30) Priority: 07.02.2025 US 202519047923
(71) Applicant: Allegro MicroSystems, LLC, Manchester, NH 03103 (US)
(72) Inventor: DAIGLE, Tyler, Scarborough, 04074 (US)
(74) Representative: South, Nicholas Geoffrey

(57) **Abstract**

A magnetoresistance sensing device includes an on-chip coil capable of generating a magnetic field measured by a wheat stone bridge. The on-chip coil is used in a compensation loop and constructed in parallel with a main signal path using a separate, matched xMR compensation bridge. The separate xMR bridge allows generating and measuring a compensation signal continuously and differentially, which improves signal fidelity without introducing noise into the primary signal path. One or more chopper switches are provided to eliminate offset and flicker noise.

## Description

### BACKGROUND

Magnetic field sensors are used in a variety of applications, including, but not limited to, angle sensing that senses an angle of a direction of a magnetic field, current sensing that senses a magnetic field generated by a current carried by a current-carrying conductor, magnetic switching that senses the proximity of a ferromagnetic object. Magnetic field sensors are also used in rotation detection sensing passing ferromagnetic articles, for example, magnetic domains of a ring magnet or a ferromagnetic target (e.g., gear teeth) where the magnetic field sensor is used in combination with a back-biased or other magnet.

In certain applications, magnetic field sensors include magnetoresistance (MR) elements. These elements have an electrical resistance that changes in the presence of an external magnetic field. Spin valves are a type of magnetoresistance element formed from two or more magnetic materials or layers. The simplest form of a spin valve has a reference (or magnetically fixed) layer and a free layer. The resistance of the spin valve changes as a function of the magnetic alignment of the reference and free layers. Typically, the magnetic alignment of the reference layer does not change, while the magnetic alignment of the free layer moves in response to external magnetic fields.

In some cases, a spin valve may also have a bias. The bias may be generated by one or more magnetic layers (bias layers) that are magnetically coupled to the free layer. In the absence of an external magnetic field, the bias layers may cause the magnetic alignment of the free layer to default to a predetermined alignment. The magnetic coupling between the bias layers and the free layer is relatively weak so that an external field can override the bias and realign the magnetic alignment of the free layer.

In known sensors, MR transducers are prone to sensitivity variation over temperature and lifetime, which results difficult and expensive automated testing equipment (ATE) testing over temperature and increased lifetime error specifications.

### SUMMARY

Aspects of the present disclosure relate to magnetoresistance sensing devices including an on-chip coil capable of generating a magnetic field measured by a wheat stone bridge. The on-chip coil may be used in a compensation loop and constructed in parallel with a main signal path using a separate, matched xMR compensation bridge. The separate xMR bridge may allow generating and measuring a compensation signal continuously and differentially, which improves signal fidelity without introducing noise into the primary signal path. One or more chopper switches are optionally provided to eliminate offset and flicker noise.

According to one aspect, a magnetic field sensor integrated circuit (IC) package device may include a first bridge including a first group of arrays and a second bridge including a second group of arrays. Each of the first group of arrays and the second group of arrays may have xMR elements, each having a pinning direction. An on-chip coil routed under the xMR elements may be configured to conduct current for generating a first magnetic field on the xMR elements of the first group of arrays and the second group of arrays The first group of arrays may be configured to sense changes in an applied magnetic field and the second group of arrays may be configured to sense a coil-generated magnetic field.

According to another aspect a method may include arranging a first bridge including a first group of arrays and a second bridge including a second group of arrays Each of the first group of arrays and the second group of arrays may have xMR elements, each having a pinning direction. An on-chip coil may be provided and routed under the xMR elements. The on-chip coil may be configured to conduct current for generating a first magnetic field on the xMR elements of the first group of arrays and the second group of arrays. The first group of arrays may be configured to sense changes in an applied magnetic field and the second group of arrays may be configured to sense a coil-generated magnetic field.

In another aspect, a sensing bridge may include a first bridge including a first group of arrays and a second bridge including a second group of arrays. Each of the first group of arrays and the second group of arrays may have xMR elements each having a pinning direction. An on-chip coil may be routed under the xMR elements in a serpentine pattern with odd-numbered U-turns skipping adjacent columns of the xMR elements. The on-chip coil may be configured to conduct current for generating a first magnetic field on the xMR elements of the first group of arrays and the second group of arrays. A first frontend gain stage may be connected to the first group of arrays. A second frontend gain stage may be connected to the second group of arrays and summed with a reference voltage to generate a compensation signal to control an input bias. The first group of arrays may be configured to sense changes in an applied magnetic field. The second group of arrays may be configured to sense a fixed coil-generated magnetic field and may be immune to the applied magnetic field.

The devices and methods may further include, alone or in combination, one or more of the following features. The first group of arrays may be immune to the coil-generated magnetic field. The second group of arrays may be immune to the applied magnetic field. The second bridge may be configured to compensate for sensitivity variation in the first bridge. The first bridge and the second bridge may be connected in series. The first bridge and the second bridge may be connected in parallel. The coil-generated magnetic field may be a fixed magnetic field. The first group of arrays may be connected to a first frontend stage and the second group of arrays is connected to a second frontend stage. An output of the second frontend stage may be summed with a reference voltage to generate a compensation signal to control an input bias. The applied magnetic field may be applied to the xMR elements in the first and second groups of arrays in a first direction. All xMR elements may be pinned in a first direction. The on-chip coil may be formed in one or more metal layers of the device. The on-chip coil may be formed in one single metal layer. A routing of the on-chip coil may be serpentine and include a plurality of U-turns. Odd number U-turns of the on-chip coil may skip an adjacent column of the xMR elements. A chopper switch may connected to the second group of arrays. A first bias input and a second bias input may be connected to the chopper switch. The chopper switch may be configured to alternate between supplying an input to the second group of arrays and bypassing the second group of arrays.

### BRIEF DESCRIPTION OF THE DRAWINGS

The foregoing features of the disclosure, as well as the disclosure itself may be more fully understood from the following detailed description of the drawings. The drawings aid in explaining and understanding the disclosed technology. Since it is often impractical or impossible to illustrate and describe every possible embodiment, the provided figures depict one or more exemplary embodiments. Accordingly, the figures are not intended to limit the scope of the invention. Like numbers in the figures denote like elements.
FIG. 1 is a schematic representation of an example sensor having on a coil for on-chip magnetic field generation, according to aspects of the present disclosure;
FIG. 2 is schematic representation of an MR bridge with MR elements, according to aspects of the present disclosure;
FIG. 3 is a schematic representation of a sensing bridge formed of pinned xMR elements and subject to an on-chip coil generated field, according to aspects of the present disclosure;
FIG. 4 is a schematic representation of a sensor including arrays of xMR elements aligned with a coil to form a magnetometer, according to aspects of the present disclosure;
FIG. 5 is a schematic representation of a sensor including arrays of xMR elements aligned with a coil to form a gradiometer, according to aspects of the present disclosure;
FIG. 6A is a schematic representation of a sensing bridge formed of pinned xMR elements with chopper switches and subject to an on-chip coil generated field according to aspects of the present disclosure;
FIG. 6B is a schematic representation of the sensing bridge of FIG. 6A with chopper switches in a first state, according to aspects of the present disclosure;
FIG. 6C is a schematic representation of the sensing bridge of FIG. 6A with chopper switches in a second state, according to aspects of the present disclosure;
FIG. 7A is a schematic representation of a front end gain stage, according to aspects of the present disclosure;
FIG. 7B is a schematic representation of a front end gain stage, according to aspects of the present disclosure; and
FIG. 8 shows a schematic representation of an example computer that can perform at least a portion of the processing described herein.

### DETAILED DESCRIPTION

The detailed description set forth below, in connection with the appended drawings, is intended as a description of various configurations and is not intended to represent the only configurations in which the concepts described herein may be practiced. The detailed description includes specific details for providing a thorough understanding of the various concepts. It will be apparent to those skilled in the art, however, that these concepts may be practiced without these specific details. In some instances, well-known structures and components are shown in block diagram form in order to avoid obscuring such concepts.

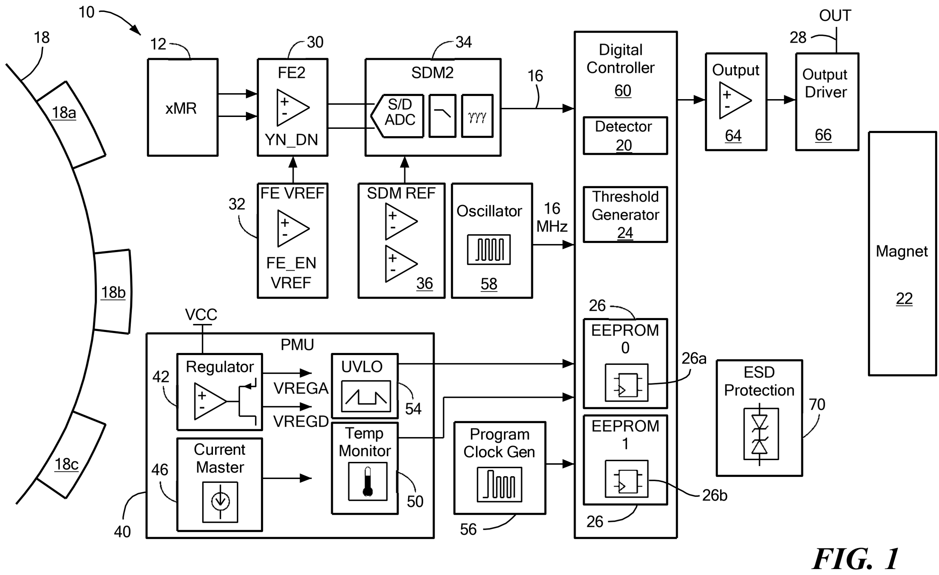

FIG. 1 shows an example magnetoresistance (MR) magnetic field sensor 10 having on-chip magnetic field generation for MR element stimulation in accordance with example embodiments of the disclosure. The sensor 10 is configured to generate a magnetic field signal 16 indicative of a magnetic field associated with a target 18 and a detector 20 responsive to the magnetic field signal and to a threshold level from a threshold generator 24 to generate a sensor output signal 28 containing transitions associated with features of the target in response to the magnetic field signal crossing the threshold level.

The target 18 can have a variety of forms, including, but not limited to a gear having gear teeth 18a - 18c or a ring magnet having one or more pole pair. Also, linear arrangements of ferromagnetic objects that move linearly are possible. In the example embedment of FIG. 1, magnetic field sensor 10 may take the form of a rotation detector to detect passing gear teeth, for example, gear teeth 18a-18c of a ferromagnetic gear or, more generally target object 18. A permanent magnet 22 can be placed at a variety of positions proximate to the gear 18, resulting in fluctuations of a magnetic field proximate to the gear as the gear rotates in a so-called "back-bias" arrangement.

Features of the target 18 are spaced from the sensing elements 12 by an airgap. Although intended to be fixed once the sensor 10 is in place in a particular application, the airgap can vary for a variety of reasons. A difference between angles of the transitions of the sensor output signal 28 and locations of the associated features 18a - 18c of the target 28 is referred to as a "hard offset."

Sensing elements 12 can take a variety of forms, such as xMR elements, as may be arranged in one or more bridge or other configurations in order to generate one or more single-ended or differential signals indicative of the sensed magnetic field. As used herein, xMR elements may refer to, or include, giant magnetoresistance (GMR) and tunnel magnetoresistance (TMR) technologies. A front-end amplifier 30 can be used to process the magnetic field sensing element output signal to generate a further signal for coupling to an analog-to-digital converter (ADC) 34 as may include one or more filters, such as a low pass filter and/or notch filter, and as may take the form of a sigma delta modulator to generate a digital magnetic field signal 16. Features of the magnetic field signal processing can include a front-end reference 32 and a sigma delta reference 36.

Sensor 10 includes a power management unit (PMU) 40 as may contain various circuitry to perform power management functions. For example, a regulator 42 can output a regulated voltage for powering analog circuitry of the sensor (VREGA) and/or a regulated voltage for powering digital circuitry of the sensor (VREGD). A bias current source 46, a temperature monitor 50 and an undervoltage lockout 54 can monitor current, temperature, and voltage levels and provide associated status signals to a digital controller 60. A clock generation element 56 and an oscillator 58 are coupled to the digital controller 60.

Digital controller 60 processes the magnetic field signal 16 to determine the speed, position, and/or direction of movement, such as rotation of target 18 and outputs one or more digital signals to an output protocol module 64. More particularly, controller 60 determines the speed, position, and/or direction of target 18 based on the magnetic field signal 16 and can combine this information with fault information in some embodiments to generate the sensor output signal 28 in various formats. The output of module 64 is fed to an output driver 66 that provides the sensor output signal 28 in various formats, such as a so-called two-wire format in which the output signal is provided in the form of current pulses on the power connection to the sensor or a three-wire format in which the output signal is provided at a separate dedicated output connection. Formats of the output signal 28 can include variety of formats, for example a pulse-width modulated (PWM) signal format, a Single Edge Nibble Transmission (SENT) format, a Serial Peripheral Interface (SPI) format, a Local Interconnect Network (LIN) format, a CAN (Controller Area Network) format, an Inter-Integrated Circuit (I²C) format, or other similar signal formats. Sensor 10 can further include electrostatic discharge (ESD) protection 70.

The digital controller 60 includes detector 20, threshold generator 24, and memory 26 such as EEPROMs 26a, 26b. Memory 26 can be used to store values for various sensor functionality including storing function coefficients for use by the threshold generator 24 in generating the adaptive threshold levels for use by detector 20.

Detector 20 is coupled to receive the threshold level thus generated and the magnetic field signal 16 and compare the received levels to generate a binary, two-state, detector output signal that has transitions when the signal 16 crosses the threshold level. Movement speed of the target 18 can be detected in accordance with the frequency of the binary signal.

It should be appreciated that a direction of rotation of the target 28 may be determined in embodiments containing multiple sensing elements 12 configured to generate phase separated magnetic field signals (as are sometimes referred to as channel signals), in which case the direction of rotation can be determined based on a relative phase or relative time difference (e.g., lag or lead) of a particular edge transition of detector output signals associated with the phase separated magnetic field signals.

It is understood that embodiments of MR-based sensing elements are useful in a wide variety of magnetic sensors. While an example sensor is shown and described above, any practical magnetic sensor in which MR sensing elements are desirable can be provided. For example, MR sensing elements are useful in many magnetic positions and angle sensors that require high resolution. Further example sensors in which MR-based sensing elements are shown and described below.

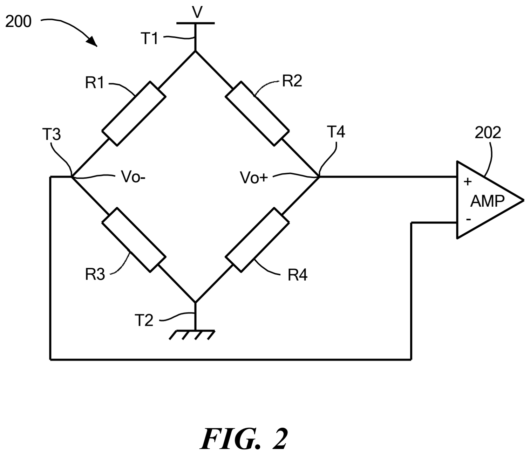

FIG. 2 shows an example xMR bridge 200 having a first resistor R1, a second resistor R2, a third resistor R3, and fourth resistor R4 coupled in a bridge configuration, which can correspond to the sensing elements 12 of FIG. 1. A first terminal T1 is coupled to a voltage or current source and a second terminal T2 is coupled to ground or negative voltage or current source. A third terminal T3 provides a first differential output signal Vo- and a fourth terminal T4 provides a second differential output signal Vo+. The differential output Vo+, Vo- of the bridge can be provided to an amplifier AMP 202 or other circuitry for processing of the output of the magnetic field sensing elements, such as described above.

Aspects of the present disclosure provide an MR sensing device utilizing an on-chip coil capable of generating a magnetic field measured by a Wheatstone bridge. Depending on bridge routing (e.g., the pinning directions of the xMR elements and their alignment with the magnetic fields), the on-chip coil can generate a differential mode output, common mode output, or no output. The on-chip coil may be used in a compensation loop and constructed in parallel with the main signal path using a separate, matched xMR compensation bridge. According to one aspect, a separate xMR bridge may allow generating and measuring a compensation signal continuously and differentially, which may improve signal fidelity without introducing noise into the primary signal path.

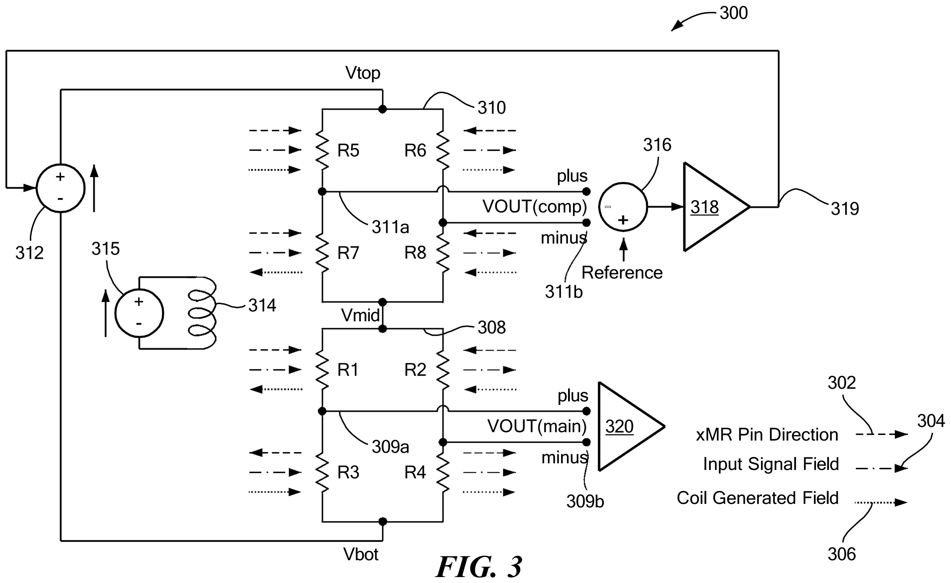

FIG. 3 is a schematic representation, according to aspects of the present disclosure, of a sensing bridge 300 including a main bridge 308 and a matched compensation bridge 310. The sensing bridge 300 may include pinned xMR elements (e.g., tunnel magneto resistor (TMR) or giant magneto resistor (GMR)), for example elements R1-R8, subject to a magnetic field generated by an on-chip coil 314 and coil voltage input 315. The sensing bridge 300 can be biased by a bias element 312 with either voltage or current. Output of the sensing bridge 300 can be measured as either voltage or current.

In embodiments, the sensing bridge 300 may self-compensate xMR transducer sensitivity using a continuous-time analog loop and the on-chip coil 314. According to one aspect, the compensation loop may run in parallel with the primary signal path and does not limit the bandwidth. To compensate for sensitivity variation, the sensing bridge 300 may be split into two discrete bridges, including a main bridge 308 used for a primary signal path and a compensation bridge 310 used for xMR sensitivity measurements. According to one aspect, the bridges may be connected in series or in parallel, depending on the application, as described herein.

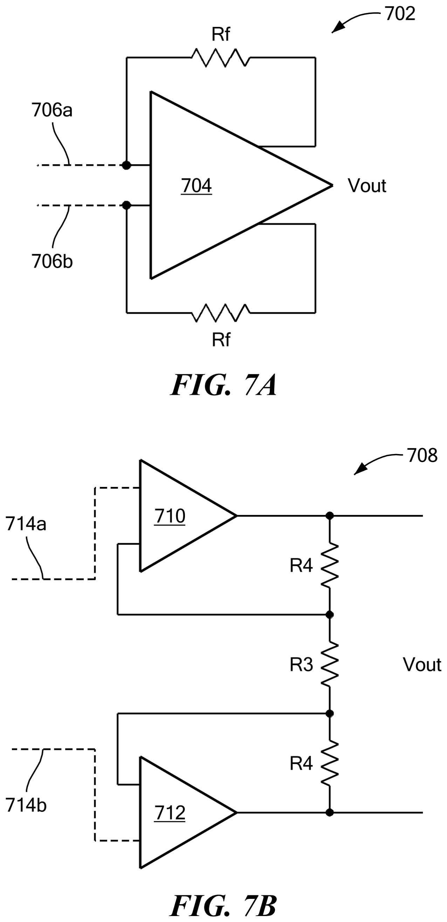

According to one aspect, the main bridge 308 may include first, second, third, and fourth MR elements R1, R2, R3, R4 having respective pinning orientations indicated by respective arrows 302. A first leg of the main bridge 308 may extend from node VMID to the first MR element R1, to the third MR element R3 to node VBOT. A second leg of the main bridge 308 may extend from node VMID to the second MR element R2, to the fourth MR element R4 to node VBOT. The first and fourth MR elements R1, R4 may comprise the same nominal resistance and the second and third MR elements R2, R3 may comprise the same nominal resistance. Nodes VOUT(main)_plus 309a, VOUT(main)_minus 309b may provide an output voltage VOUT(main) that corresponds to an applied magnetic field in the sensitive axis due to changes in resistance in the presence of the field. The output voltage VOUT(main) may be applied to the main frontend gain stage 320. The main frontend gain stage 320 may be or include a frontend stage like those shown and described in connection with FIGS. 7A-7B. As described more fully below, arrows 304 indicate the orientation of input signal field on the bridge resistors R1, R2, R3, R4 and arrows 306 indicate the orientation of an on-chip coil generated field.

According to one aspect, the compensation bridge 310 may include fifth, sixth, seventh and eighth MR elements R5, R6, R7, R8 having respective pinning orientations indicated by respective arrows 302. A first leg of the compensation bridge 310 may extend from node VTOP to the fifth MR element R5, to the seventh MR element R7 to node VMID. A second leg of the compensation bridge 310 may extend from node VTOP to the sixth MR element R6, to the eighth MR element R8 to node VMID. The fifth and eighth MR elements R5, R8 may comprise the same nominal resistance and the sixth and seventh MR elements R8, R9 may comprise the same nominal resistance. Nodes VOUT(comp)_plus 311a, VOUT(comp)_minus 311b may provide an output voltage VOUT(comp) that corresponds to an applied magnetic field in the sensitive axis due to changes in resistance in the presence of the field. The output voltage VOUT(comp) may be summed with a fixed reference 316 (e.g. voltage or current) and applied to a compensation frontend gain stage 318.. The compensation frontend gain stage 318 may be or include a frontend stage like those shown and described in connection with FIGS. 7A-7B. The output 319 of the compensation frontend gain stage 318 may be used to control both the main bridge 308 and compensation bridge 310 bias such that the compensation bridge 310 measures a fixed value. As described more fully below, arrows 304 indicate the orientation of input signal field on the bridge resistors R5, R6, R7, R8 and arrows 306 indicate the orientation of an on-chip coil generated field.

According to one aspect, the main bridge 308 may be connected to the frontend gain stage 320 and configured to be sensitive only to a signal-generated magnetic field, as described herein. According to one aspect, a fixed magnetic field may be generated at and sensed in the compensation bridge 310 using the on-chip integrated coil 314. The compensation bridge 310 may respond differentially to the coil generated field and may be immune to the signal field. Accordingly, a fixed (e.g., DC) coil generated magnetic field can be used. Generating and sensing the coil field differentially may eliminate the need for high-pass filter coupling capacitors and improve the signal-to-noise (SNR) ratio. The output of the compensation gain stage 318 may be used to control the bias 312 of both the main bridge 308 and compensation bridge 310 such that the compensation bridge 310 measures a fixed value. Accordingly, any change in xMR sensitivity over temperature, environment, stress conditions, and/or stray magnetic field may cause a bridge biasing adjustment which would result in a flat (e.g., unchanged) main transducer bridge plus frontend gain sensitivity.

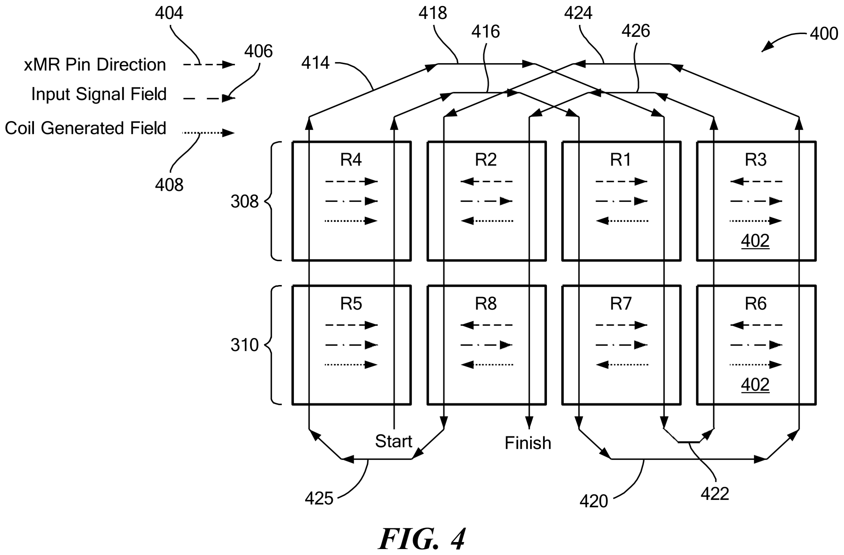

According to one aspect, for sensitivity compensation to work, the coil-generated magnetic field may not change (or it may exhibit minor changes relative to xMR sensitivity change). This may require a flat current pass through the coil 314, independent to temperature. In addition, xMR sensitivity of the main bridge 308 and compensation bridge 310 may need to match. According to one aspect, this may be achieved by interdigitating the xMR devices in the layout (e.g., mixing the xMR devices from the main bridge 308 and the compensation bridge 310 such that each row of devices (see FIG. 4) contains elements from each bridge). The signal path frontend gain may need to match the compensation frontend gain. This may be achieved by using the same resistor type and unit area.

As shown, the main bridge 308 may be configured in series with the compensation bridge 310, which may force the bias current of each bridge to be identical. According to one aspect, this configuration may be a magnetometer bridge. In such a configuration, the input signal field 304, may be applied in the same direction for all xMR devices, R1-R8 (i.e., the applied signal is in the same polarity). Further, the xMR devices may be pinned separately. For example, one half of the devices (e.g., R1, R4, R5 and R7) may be pinned left-to-right (e.g., 0°) and the other half of the devices (e.g., R2, R3, R6 and R8) may be pinned right-to-left (e.g., 180°). The differential output (VOUT(main)) of the main bridge 308 may be representative of the input signal field and the output (VOUT(comp)) of the compensation bridge 310, whether it is a differential output or common mode output, may be immune to the input signal field. The on-chip coil 314 may be routed such that the differential output of the compensation bridge 310 may be representative of coil-generated field 306 while the differential and common mode outputs of the main bridge 308 may be immune to coil-generated field 306.

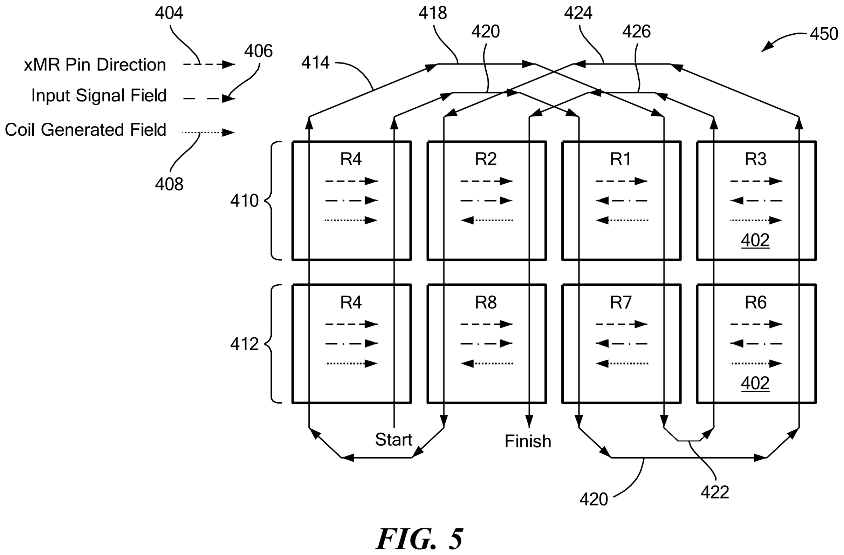

As described above, the MR sensing device, 300 may include an on-chip coil 314 to generate a lateral magnetic field. In embodiments, the on-chip coil 314 may be routed in one or more metal layers. The coil 314 may comprise metal routes running underneath the xMR elements such that the current flow-induced magnetic field is generated perpendicularly above the coil 314 and through the xMR elements. According to one aspect, the coil-generated field may run parallel to the direction in which the xMR elements are pinned. In the case of a magnetometer MR bridge like that shown in FIG. 3, xMR devices may be pinned in two opposing directions (FIG. 4). Alternatively, in the case of a gradiometer MR bridge, devices may be pinned in the same direction (FIG. 5). To generate a field to stimulate the xMR devices, the coil routes may run in a serpentine manner for consistent field application in relation to pinning orientation, as described more fully below.

Turning now to FIG. 4, a schematic representation of a sensor 400 is shown including arrays of xMR elements 402 aligned with an on-chip coil 414 to form a magnetometer, according to aspects of the present disclosure. The xMR elements 402 may be the same or similar to elements R1-R8 shown in FIG. 3 and described above, in which elements R1-R4 form the main bridge 308 and elements R5-R8 for the compensation bridge 310. According to one aspect the on-chip coil 414 may be implemented by running a single metal trace (or set of metal traces) under the xMR elements and looping back and forth in a serpentine pattern until the entire MR bridge is covered. In one aspect, the coil configuration described herein does not increase area or coil resistance while also not decreasing a coupling factor. Depending on the pinning and element configuration, the bridge response from coil-generated signal can either be differential, common, or immune (e.g., no output).

The coil generated field, according to aspects of the present disclosure, may increase certain xMR elements' resistance and decrease others. This may be achieved by "leap-frogging" every other column of xMR devices in the serpentine pattern. For example, according to one aspect, the coil 414 may start under a first column (elements R4/R5). A first U-turn 416 of the coil 414 may skip a second column (elements R2/R8) and continue its run under a third column (R1/R7). A second U-turn 420 runs the coil 414 under a fourth column (R3/R6). The coil 414 may continue with a third U-turn 424 skipping the third column (R1/R7) and continuing under the second column (R2/R8). A fourth U-turn 425 may run the coil, beginning a second loop, under the first column (R4/R5), after which a fifth U-turn may skip the second column (R2/R8) and run under the third column (R1/R7). A sixth U-turn 422 may run the coil 414 under the fourth column (R3/R6). A seventh U-turn 426 may skip the third column (R1/R7) and run the coil 414 under the second column R2/R8, where the coil may finish. Accordingly, the coil 414 may "leap-frog" with the odd numbered U-turns in the coil 414 skipping the adjacent column of xMR elements. While the schematic representation of FIG. 4 shows two complete loops of the on-chip coil 414, one skilled in the art will recognize that additional loops may be provided to increase coupling.

In the illustrative sensor 400, columns of xMR elements 402 may represent similarly pinned and excited elements in a magnetometer configuration. For example, elements R1-R8 may have respective pinning orientations indicated by respective arrows 404, while an input field signal orientation is indicated by arrows 406 and the on-chip coil generated field is indicated by arrows 408. In a magnetometer configuration, the polarity of the input field signal 406 may be the same for all elements (e.g., left-to-right) and xMR pinning may be done at 0° (e.g., left-to-right) and 180° (e.g., right-to-left).

Accordingly, four combinations of pin direction 404 and coil generated field direction 408 are possible: a first combination may include both the pin direction 404 and coil generated field direction 408 at 0°, resulting in a resistance decrease when the coil current increases. A second combination may include the pin direction 404 at 0° and coil generated field direction 408 at 180°, resulting in a resistance increase when the coil current increases. The same result occurs for the third combination in which the pin direction 404 is at 180° and coil generated field direction 408 is at 0°. In the fourth combination, both the pin direction 404 and coil generated field direction 408 are at 180°, resulting in a resistance decrease when the coil current increases.

According to aspects of the present disclosure the routing of the bridge elements (e.g. R1-R8) may determine that bridge's response type. For example, a similar pinning and field alignment in each leg of a bridge (e.g., left and right legs) may yield a bridge output that is immune to that field. For example, returning to FIG. 3, in the compensation bridge 310, the pinning direction 302 of the left leg elements (R5, R7) may be similar to the input field signal direction 304 (e.g., both pointing left-to-right). Similarly, both right leg elements (R6, R8) have a pinning direction (e.g., right-to-left) opposite the input field signal 304 (e.g., left-to-right). Accordingly, the compensation bridge 310 output may be immune to the input field signal 304.

Further, a similar pinning and field alignment on diagonal elements in a bridge may result in a bridge output in a differential mode that responds to the field. For example, in the compensation bridge 310, diagonal elements R5 and R8 have a pinning direction 302 that is the same as the coil generated field 306 across those elements. Similarly, diagonal elements R6 and R7 both have a pinning direction opposite the coil generated field 306. Accordingly, the compensation bridge 310 may respond (e.g., is not immune to) to the coil generated field 306.

According to one aspect, a similar pinning and field alignment on the top and bottom elements may result in a common mode bridge output that responds to that field.

Alternatively, a sensor may include bridge elements configured as a gradiometer. FIG. 5 is a schematic representation of a sensor 450 including arrays of xMR elements aligned with a coil to form a gradiometer, according to aspects of the present disclosure. The sensor 450 may be similar to the sensor 400 shown in FIG. 4 and described above, where like reference numbers indicate like elements, however the pinning direction 404 and input signal field 406 may be configured differently for certain elements.

As shown in the schematic of FIG. 5, the gradiometer bridge sensor 450 may be formed using xMR elements R1-R8 all having the same pin direction 404 while the input signal field is either at 0° or 180°. In contrast to the magnetometer sensor 400 shown in FIG. 4, the pinning direction 404 of elements R2, R3, R6, and R8 has changed. The input signal field 406 for elements R1, R3, R6 and R7 has changed to a 180° polarity, while the input signal field 406 for elements R2, R4, R5 and R8 are at 0°. The output signal of the gradiometer, according to one aspect, is measured differentially.

According to one aspect of the disclosure a compensation bridge, as described herein, may can optionally be chopped using one or more switches to offset and flicker noise. To reduce ripple in the signal path without dedicated ripple reduction circuits, according to one aspect, the main bridge bias can be used to directly average the chop phases. This may eliminate the chop phase-to-phase offset induced ripple without increasing area or compromising signal path bandwidth.

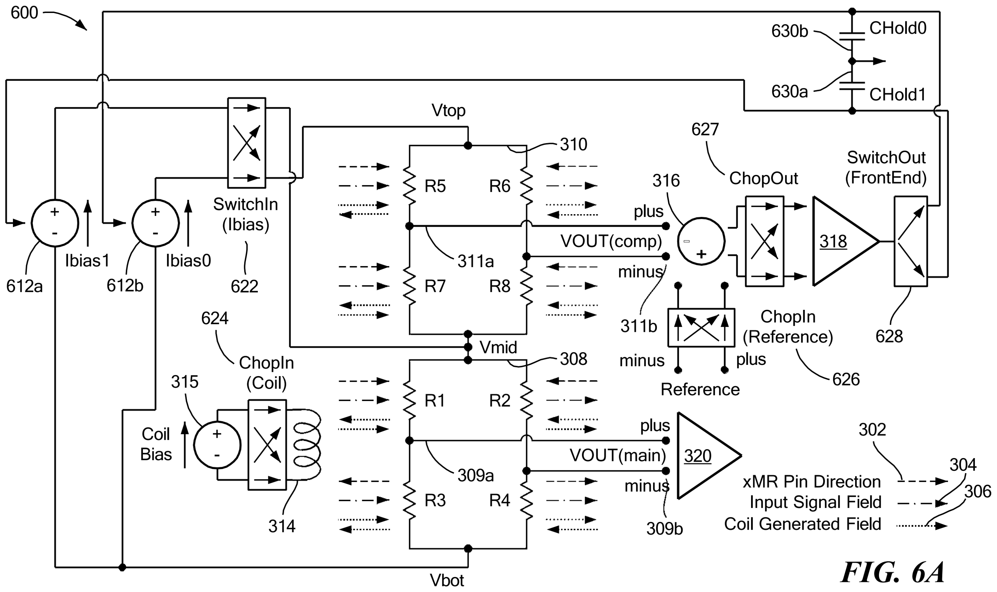

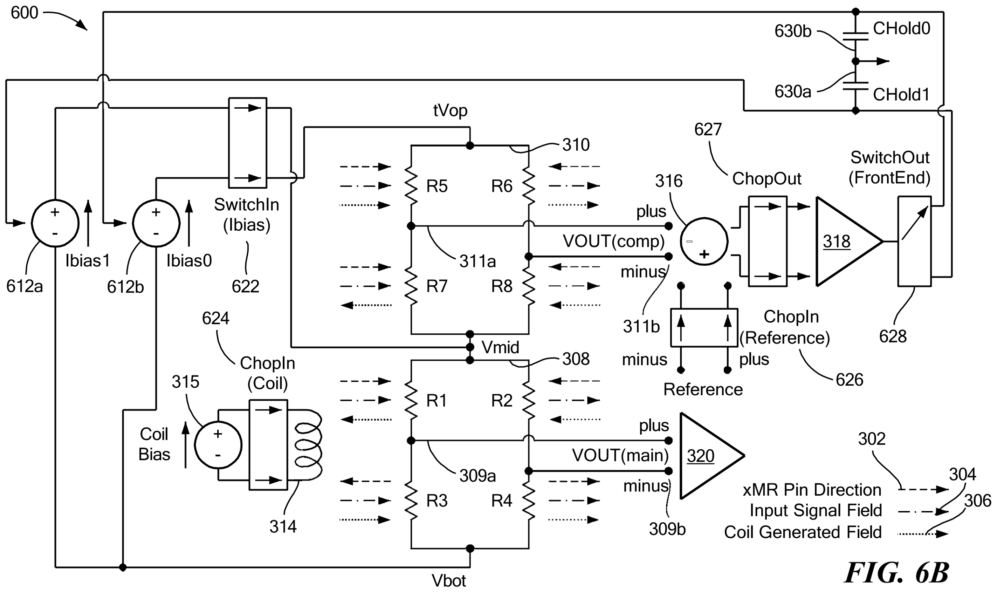

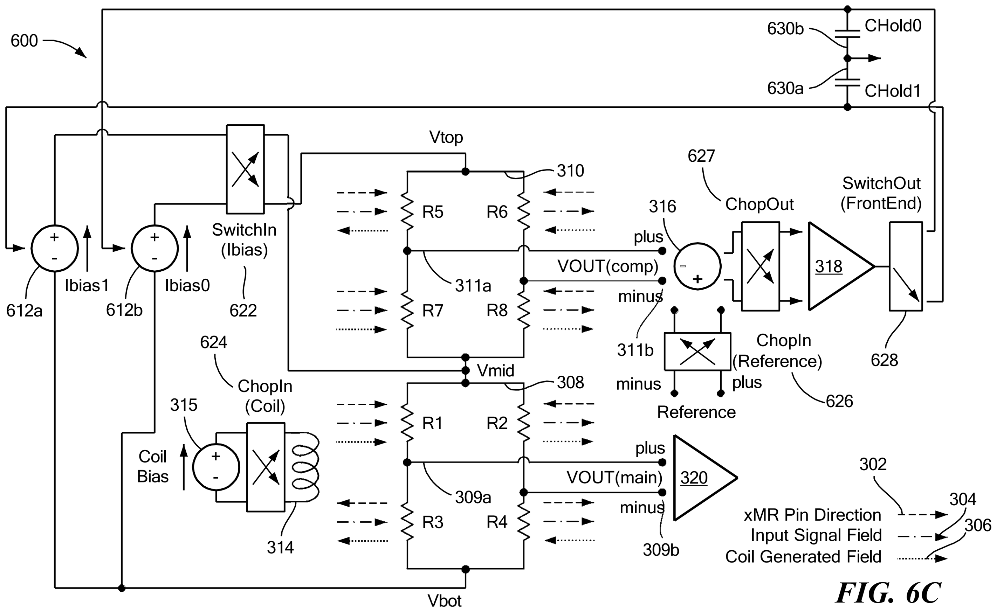

FIGS. 6A-6C depict a schematic representation of a sensing bridge 600 formed of pinned xMR elements with chopper switches and subject to an on-chip coil generated field, according to aspects of the present disclosure. The sensing bridge 600 may be similar to the sensing bridge 300 of FIG. 3, where like reference numbers refer to like elements. FIG. 6A shows the schematic representation of the sensing bridge 600 without reference to a chop phase, while FIG. 6B depicts the sensing bridge 600 in a first chop phase and FIG. 6C shows the sensing bridge in a second chop phase.

According to one aspect, chopper switches may be included to eliminate offset and flicker noise. An input switch, SwitchIn 622, may be connected to a first current bias Ibias0 612b and a second current bias Ibias1 612a. With the main bridge 308 and the compensation bridge 310 in configured in series, the bias currents, Ibias0 and Ibias1, in separate phases, respectively, can alternate between passing through the compensation bridge 310 and bypassing the compensation bridge. For example, in a first chop phase (e.g., phase 0), shown in FIG. 6B, Ibias0 may pass through the compensation bridge 310 while Ibias1 bypasses the compensation bridge 310 and passes directly through the main bridge 308. In a second chop phase (e.g., phase 1), shown in FIG. 6C, the bias currents switch and Ibias1 may pass through the compensation bridge 310 while Ibias0 bypasses the compensation bridge 310 and passes directly through the main bridge 308. Both bias currents pass through main bridge in both chop phases, which may eliminate chop phase-to-phase offset induced ripple.

Other switches may include a ChopIn(Coil) 624 configured to reverse the coil current to invert the compensation bridge output, a ChopIn(reference) configured to invert the reference signal summed 316 with the compensation bridge 310 output, and a ChopOut switch 627 to invert the summing gain stage output. According to one aspect, a SwitchOut (FrontEnd) 628 may be configured to enable or disable each phase's bias current. For example, when enabled, the compensation front end gain stage 318 may control the bias currents. When disabled, the state of the bias currents is stored on the respective hold capacitor, CHold0 630b and CHold1 630a.

In operation, according to aspects described herein, to chop only the xMR bridge, the coil current and bridge output may both be inverted and switched (e.g., ChopIn(Coil) 624 and ChopOut 627) at a chopping frequency (*fchp*)*.* For example, the chopping frequency may be about 100kHz and an example input signal bandwidth may be about 10MHz. Since the main bridge 308 may average both chop phases, the chop frequency may be in band without causing aliasing or chop frequency tones from appearing at VOUT(main)plus-minus.

To chop the xMR and the compensation frontend gain stage 318, the coil current (ChopIn(Coil) 624), reference input (ChopIn(Reference) 626), and compensation frontend output (ChopOut 627) may be inverted and switched at the *fchp*. Depending on the offset in the compensation bridge 310, the main bridge 308 bias may experience some ripple, which may cause ripple in the signal path (especially at large signal levels). In known sensors, a low-pass filter, ripple reduction loop, and/or notch filter are added to the signal path frontend at the expense of bandwidth and added area. According to aspects of the present disclosure, to eliminate the chop phase-to-phase offset ripple from affecting the signal path a track-and-hold circuit, including respective capacitors CHold0 630b and CHold1 630a, may be added to the compensation frontend output and bias currents generated in each phase may be summed directly at the main bridge. The compensation loop plus track and hold bandwidth may only need to be high enough to update biasing from stress, temperature, or environmental changes. The bandwidth may need to be high enough to pass a signal.

Turning now to FIGS. 7A and 7B, two exemplary frontend gain stages are provided. The frontend gain stages may be the same or similar to the frontend gain stages 318 and 320 (FIGS. 3, 6A-6B) as described herein. FIG. 7A is a schematic representation of a current-driven frontend gain stage 702, according to aspects of the present disclosure. Input currents 706a, 706b, which may be for example bridge outputs, may be input to an amplifier, such as operational amplifier 704. Reference resistors Rf may be connected to the inputs 706a, 706b in parallel to the amplifier 704. The gain stage 702 outputs a voltage, Vout.

FIG. 7B is a schematic representation of a voltage-driven front end gain stage 708, according to aspects of the present disclosure. Inputs 714a, 714b, which may be for example bridge outputs may be connected to a high-impedance frontend gain stage 708, such as an instrumentation amplifier, including a first amplifier 710 and a second amplifier 712 connected in parallel with resistors R4, R3, R4 to provide an output voltage, Vout. The frontend gain stages shown in FIGS. 7A-7B are known in the art and one of ordinary skill in the art would recognize their respective form and function in conjunction with the sensing bridges, as described herein.

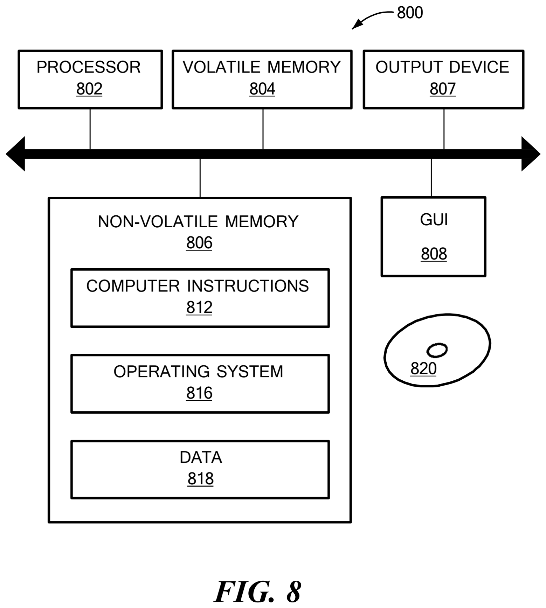

FIG. 8 shows an exemplary computer 800 that can perform at least part of the processing described herein. The computer 800 includes a processor 802, a volatile memory 804, a non-volatile memory 806 (e.g., hard disk), an output device 807 and a graphical user interface (GUI) 808 (e.g., a mouse, a keyboard, a display, for example). The non-volatile memory 806 stores computer instructions 812, an operating system 816 and data 818. In one example, the computer instructions 812 are executed by the processor 802 out of volatile memory 804. In one embodiment, an article 820 comprises non-transitory computer-readable instructions.

Processing may be implemented in hardware, software, or a combination of the two. Processing may be implemented in computer programs executed on programmable computers/machines that each includes a processor, a storage medium or other article of manufacture that is readable by the processor (including volatile and non-volatile memory and/or storage elements), at least one input device, and one or more output devices. Program code may be applied to data entered using an input device to perform processing and to generate output information.

The system can perform processing, at least in part, via a computer program product, (e.g., in a machine-readable storage device), for execution by, or to control the operation of, data processing apparatus (e.g., a programmable processor, a computer, or multiple computers). Each such program may be implemented in a high-level procedural or object-oriented programming language to communicate with a computer system. However, the programs may be implemented in assembly or machine language. The language may be a compiled or an interpreted language and it may be deployed in any form, including as a stand-alone program or as a module, component, subroutine, or other unit suitable for use in a computing environment. A computer program may be deployed to be executed on one computer or on multiple computers at one site or distributed across multiple sites and interconnected by a communication network. A computer program may be stored on a storage medium or device (e.g., CD-ROM, hard disk, or magnetic diskette) that is readable by a general or special purpose programmable computer for configuring and operating the computer when the storage medium or device is read by the computer.

Processing may also be implemented as a machine-readable storage medium, configured with a computer program, where upon execution, instructions in the computer program cause the computer to operate.

Processing may be performed by one or more programmable embedded processors executing one or more computer programs to perform the functions of the system. All or part of the system may be implemented as special purpose logic circuitry (e.g., an FPGA (field programmable gate array) and/or an ASIC (application-specific integrated circuit)).

As used herein, the term "anisotropy" or "anisotropic" refer to a particular axis or direction to which the magnetization of a ferromagnetic or ferrimagnetic layer tends to orientate when it does not experience an additional external field. An axial anisotropy can be created by a crystalline effect or by a shape anisotropy, both of which allow two equivalent directions of magnetic fields. A directional anisotropy can also be created in an adjacent layer, for example, by an antiferromagnetic layer, which allows only a single magnetic field direction along a specific axis in the adjacent layer.

In view of the above, it will be understood that introduction of an anisotropy in a magnetic layer results in forcing the magnetization of the magnetic layer to be aligned along that anisotropy in the absence of an external field. In the case of a GMR or TMR element, a directional anisotropy provides an ability to obtain a coherent rotation of the magnetic field in a magnetic layer in response, for example, to an external magnetic field.

In general, magnetic materials can have a variety of magnetic characteristics and can be classified by a variety of terms, including, but not limited to, ferromagnetic, antiferromagnetic, and nonmagnetic. Description of the variety of types of magnetic materials is not made herein in detail. However, let it suffice here to say, that a ferromagnetic material is one in which magnetic moments of atoms within the ferromagnetic material tend to, on average, align to be both parallel and in the same direction, resulting in a nonzero net magnetic magnetization of the ferromagnetic material.

An antiferromagnetic material is one in which magnetic moments within the antiferromagnetic material tend to, on average, align to be parallel, but in opposite directions in sub-layers within the antiferromagnetic material, resulting in a zero net magnetization.

As used herein, the term "magnetic field sensing element" is used to describe a variety of electronic elements that can sense a magnetic field. The magnetic field sensing element can be, but is not limited to, a Hall effect element, a magnetoresistance element, or a magnetotransistor. As is known, there are different types of Hall effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, for example, a spin valve, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of sensitivity perpendicular to a substrate, while metal based or metallic magnetoresistance elements (e.g., GMR, TMR, AMR) and vertical Hall elements tend to have axes of sensitivity parallel to a substrate.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field. As used herein, the terms "target" and "magnetic target" are used to describe an object to be sensed or detected by a magnetic field sensor or magnetic field sensing element.

Various embodiments of the concepts, systems, devices, structures and techniques sought to be protected are described herein with reference to the related drawings. Alternative embodiments can be devised without departing from the scope of the concepts, systems, devices, structures and techniques described herein. It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures and techniques are not intended to be limiting in this respect. Accordingly, a coupling of entities can refer to either a direct or an indirect coupling, and a positional relationship between entities can be a direct or indirect positional relationship.

As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).The following definitions and abbreviations are to be used for the interpretation of the claims and the specification. As used herein, the terms "comprises," "comprising, "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Unless otherwise specified, the term "substantially" refers to values that are within ±10%. For example, a first direction that is "substantially" perpendicular to a second direction may refer to a first direction that is within ±10% of making a 90° angle with the second direction.

Having described exemplary embodiments of the disclosure, it will now become apparent to one of ordinary skill in the art that other embodiments incorporating their concepts may also be used. The embodiments contained herein should not be limited to disclosed embodiments but rather should be limited only by the spirit and scope of the appended claims. All publications and references cited herein are expressly incorporated herein by reference in their entirety.

Elements of different embodiments described herein may be combined to form other embodiments not specifically set forth above. Various elements, which are described in the context of a single embodiment, may also be provided separately or in any suitable subcombination. Other embodiments not specifically described herein are also within the scope of the following claims.

## Claims

1. A magnetic field sensor IC package device, comprising:
a first bridge including a first group of arrays and a second bridge including a second group of arrays, each of the first group of arrays and the second group of arrays having xMR elements, wherein each of the xMR elements has a pinning direction; and
an on-chip coil routed under the xMR elements configured to conduct current for generating a first magnetic field on the xMR elements of the first group of arrays and the second group of arrays, wherein the first group of arrays is configured to sense changes in an applied magnetic field and the second group of arrays is configured to sense a coil-generated magnetic field.

2. The device of claim 1 wherein the first group of arrays is immune to the coil-generated magnetic field.

3. The device of claim 1 wherein the second group of arrays is immune to the applied magnetic field.

4. The device of claim 3 wherein the second bridge is configured to compensate for sensitivity variation in the first bridge.

5. The device of claim 3 wherein the first bridge and the second bridge are connected in series.

6. The device of claim 3 wherein the first bridge and the second bridge are connected in parallel.

7. The device of claim 1 wherein the coil-generated magnetic field is a fixed magnetic field.

8. The device of claim 1 wherein the first group of arrays is connected to a first frontend stage and the second group of arrays is connected to a second frontend stage.

9. The device of claim 8 wherein an output of the second frontend stage is summed with a reference voltage to generate a compensation signal to control an input bias.

10. The device of claim 1 wherein the applied magnetic field is applied to the xMR elements in the first and second groups of arrays in a first direction.

11. The device of claim 1 wherein all xMR elements are pinned in a first direction.

12. The device of claim 1 wherein the on-chip coil is formed in one or more metal layers of the device.

13. The device of claim 1 wherein the on-chip coil is formed in one single metal layer.

14. The device of claim 1 wherein a routing of the on-chip coil is serpentine and comprises a plurality of U-turns.

15. The device of claim 14 wherein odd number U-turns of the on-chip coil skip an adjacent column of the xMR elements.

16. The device of claim 1 further comprising:
a chopper switch connected to the second group of arrays; and
a first bias input and a second bias input connected to the chopper switch, wherein the chopper switch is configured to alternate between supplying an input to the second group of arrays and bypassing the second group of arrays.

17. A method comprising:
arranging a first bridge including a first group of arrays and a second bridge including a second group of arrays, each of the first group of arrays and the second group of arrays having xMR elements, wherein each of the xMR elements has a pinning direction; and
providing an on-chip coil routed under the xMR elements configured to conduct current for generating a first magnetic field on the xMR elements of the first group of arrays and the second group of arrays, wherein the first group of arrays is configured to sense changes in an applied magnetic field and the second group of arrays is configured to sense a coil-generated magnetic field.

18. The method of claim 17 wherein the second group of arrays is immune to the applied magnetic field.

19. The method of claim 18 further comprising compensating with the second bridge for sensitivity variation in the first bridge.

20. A sensing bridge, comprising:
a first bridge including a first group of arrays and a second bridge including a second group of arrays, each of the first group of arrays and the second group of arrays having xMR elements, wherein each of the xMR elements has a pinning direction;
an on-chip coil routed under the xMR elements in a serpentine pattern with odd-numbered U-turns skipping adjacent columns of the xMR elements, the on-chip coil configured to conduct current for generating a first magnetic field on the xMR elements of the first group of arrays and the second group of arrays;
a first frontend gain stage connected to the first group of arrays; and
a second frontend gain stage connected to the second group of arrays and summed with a reference voltage to generate a compensation signal to control an input bias;
wherein the first group of arrays is configured to sense changes in an applied magnetic field, the second group of arrays is configured to sense a fixed coil-generated magnetic field and is immune to the applied magnetic field.
